(19) Europäisches Patentamt
European Patent Office
Office européen des brevets

(11) **EP 4 148 434 B1**

(12) **EUROPEAN PATENT SPECIFICATION**

(45) Date of publication and mention
of the grant of the patent:
**12.03.2025 Bulletin 2025/11**

(51) International Patent Classification (IPC):
**G01R 27/06** (2006.01)    **G01R 27/32** (2006.01)

(52) Cooperative Patent Classification (CPC):
**G01R 27/06; G01R 27/32;** G01R 21/01

(21) Application number: **21196092.7**

(22) Date of filing: **10.09.2021**

(54) **METHOD OF PERFORMING A VECTOR CHARACTERIZATION, AND ELECTRONIC SYSTEM**

VERFAHREN ZUR DURCHFÜHRUNG EINER VEKTORCHARAKTERISIERUNG UND
ELEKTRONISCHES SYSTEM

PROCÉDÉ PERMETTANT D'EFFECTUER UNE CARACTÉRISATION DE VECTEUR, ET SYSTÈME
ÉLECTRONIQUE

(84) Designated Contracting States:
**AL AT BE BG CY CZ DE DK EE ES FI FR GB GR
HR HU IS IT LT LU LV MC MK MT NL NO PL PT RO
RS SE SI SK SM TR**

(43) Date of publication of application:
**15.03.2023 Bulletin 2023/11**

(73) Proprietor: **Rohde & Schwarz GmbH & Co. KG
81671 München (DE)**

(72) Inventors:
• **LLoyd, Paul Gareth
81671 München (DE)**
• **Tipton, Darren
81671 München (DE)**
• **Wanner, Robert
81671 München (DE)**
• **Roth, Alexander
81671 München (DE)**

(74) Representative: **Novagraaf Group
Chemin de l'Echo 3
1213 Onex / Geneva (CH)**

(56) References cited:
EP-A2- 1 113 637    US-A1- 2004 093 545
US-A1- 2010 213 924    US-B1- 6 724 178
US-B1- 7 400 129

• AGILENT TECHNOLOGIES: "Agilent Two-tone and Multitone Personalities for the E8267C PSG Vector Signal Generator", 6 February 2003 (2003-02-06), XP055895740, Retrieved from the Internet <URL:http://anlage.umd.edu/5988-7689EN.pdf> [retrieved on 20220225]
• "MULTITONE SIGNAL GENERATORS FOR CELLULAR AND PCS HPA EVALUATION", MICROWAVE JOURNAL, HORIZON HOUSE PUBLICATIONS, NORWOOD, MA, US, vol. 42, no. 5, 1 May 1999 (1999-05-01), pages 354, 360, XP000913210, ISSN: 0192-6225
• GUO XIAOTAO ET AL: "Difference between single-tone and multi-tone excitations in RF channel measurement", PROCEEDINGS OF 2014 3RD ASIA-PACIFIC CONFERENCE ON ANTENNAS AND PROPAGATION, IEEE, 26 July 2014 (2014-07-26), pages 806 - 809, XP032710292, DOI: 10.1109/APCAP.2014.6992621
• ROHDE&SCHWARZ: "Generation of Vector Signals at Microwave Frequencies Application Note", 1 July 2009 (2009-07-01), XP055895557, Retrieved from the Internet <URL:https://www.rohde-schwarz.com/at/file/1GP76_1E.pdf> [retrieved on 20220225]

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Embodiments of the present invention generally relate to a method of performing a vector characterization based on a scalar measurement. Embodiments of the present invention further relate to an electronic system for performing a vector characterization based on a scalar measurement.

Many electronic devices that process electromagnetic signals have to be tested with regard to different characteristics. One typical type of tests is performed by generating a test signal by means of a vector signal generator, supplying a device under test with the generated test signal, and measuring a response of the device under test to the test signal.

For example, the test signal may be a single continuous wave (CW) signal, a multi-tone signal comprising at least two CW signals, or a frequency comb.

Accordingly, for these types of measurements, a vector signal generator and a vector signal analyzer, or a vector network analyzer are needed.

Moreover, the individual components need to be calibrated in order to be able to test the device under test properly.

Agilent Technologies: "Agilent Two-tone and Multitone Personalities for the E8267C PSG Vector Signal Generator", 6 February 2003 (2003-02-06), XP0558957 40, URL:http://anlage.umd.edu/5988-7689EN.pdf discloses a vector signal generator that is configured to generate a multi-tone signal. The vectors signal generator is configured to control the relative tone spacing, the relative tone power, and the initial tone phase. Further, testing of a device under test with a multi-tone signal having maximum peak-to-average ratio is disclosed.

"MULTITONE SIGNAL GENERATORS FOR CELLULAR AND PCS HPA EVALUATION", MICROWAVE JOURNAL, HORIZON HOUSE PUBLICATIONS, NORWOOD, MA, US, vol. 42, no. 5, 1 May 1999 (1999-05-01), page 354, 360, XP000913210, ISSN: 0192-6225 discloses a multi-tone signal generator that is configured to generate up to 16 simultaneous output signals. The signal generator comprises a phase-alignment subroutine that permits the user to simulate a signal with controlled and repeatable peak power conditions.

GUO XIAOTAO ET AL: "Difference between single-tone and multi-tone excitations in RF channel measurement", PROCEEDINGS OF 2014 3RD ASIA PACIFIC CONFERENCE ON ANTENNAS AND PROPAGATION, IEEE, 26 July 2014 (2014-07-26), pages 806-809, XP032710292, DOI: 10.1109/APCAP.2014.6992621 describes theoretical background of performing nonlinearity measurements by means of a vector network analyzer and a multi-tone generator.

The object of the present invention is to provide a method of performing a vector characterization as well as an electronic system for performing vector characterization with a simplified measurement setup.

According to the invention, the problem is solved by a method of performing a vector characterization based on a scalar measurement according to claim 1.

Therein and in the following, the term "vector characterization" is understood to denote a characterization of a signal that involves determining both the phase of the signal as well as the amplitude and/or power of the signal. Accordingly, the respective vector characterization corresponds to the characterization that is usually obtained by means of a vector measurement.

The term "scalar measurement" is understood to denote a measurement of a signal that involves determining only the amplitude and/or power of the signal.

Moreover, the term "mean power" is understood to denote an average power. For example, the mean power may be a root mean square power. However, other averaging techniques may also be used.

The method according to the present invention is based on the idea to use power parameters of the multi-tone signal, namely the peak power and the mean power, as a measure for phase relations between the at least three CW signals of the multi-tone signal.

In general, the ratio of the peak power and the mean power for multi-tone signals comprising only two CW signals is independent of the phase relation between the two CW signals, as long as the two CW signals have different center frequencies.

However, for three and more CW signals having pairwise different center frequencies, the ratio of the peak power and the mean power depends on the phase differences between the individual CW signals.

Accordingly, the phases of the CW signals can be set to be "in phase" by varying the phase of the at least one of the at least three CW signals until the ratio of the peak power and the mean power reaches its maximum, namely about 4.78 dB.

The phases of the CW signals can be set to be "opposite in phase" or "anti-phase" by varying the phase of the at least one of the at least three CW signals until the ratio of the peak power and the mean power reaches its minimum.

This method can be used for multiple different applications.

For example, the method is used in order to calibrate a signal generator, particularly a vector signal generator. Alternatively or additionally, the method is used to perform measurements of transfer characteristics and/or reflectivity characteristics of a device under test. Alternatively or additionally, the method is used to generate a frequency comb with predefined properties. These applications will be described in more detail hereinafter.

Therein, only a scalar measurement device is necessary in order to set the phases of the CW signals. In other words, no vector signal analyzer or similar vector measurement devices are necessary in order to perform the measurements described above. Nevertheless, the vector characterization is obtained. Thus, the measurement setup is simplified and the costs of the measurement setup are reduced.

For instance, the signal generating device is configured to vary amplitudes and phases of the at least three CW signals, as is described in more detail below.

The phases (and optionally the amplitudes) of the at least three CW signals may be added to a database such that the corresponding settings of the signal generating device are saved in the database. For future measurements and/or for comparison purposes, the signal generating device may access the database and the corresponding settings may be loaded from the database into the signal generating device such that the signal generating device does not have to be calibrated again.

Thus, the database may be a lookup table with a plurality of possible settings of the signal generating device, wherein different settings may correspond to different first sets of CW signals, i.e. to different multi-tone signals comprising different first sets of CW signals.

According to an aspect of the present invention, the signal generating device is a vector signal generator. Accordingly, the signal generating device may be configured to generate the multi-tone signal with arbitrary amplitudes and/or phases of the at least three CW signals. Particularly, the signal generating device may be configured to generate a digitally modulated signal.

In an embodiment of the present disclosure, the signal generating device is configured to vary amplitudes of the at least three CW signals, particularly wherein the amplitudes of the at least three CW signals are set based on the determined mean power. For example, the amplitudes of the at least three CW signals may be set solely based on the mean power.

Particularly, the amplitudes of the at least three CW signals may be set in an iterative manner. First, a single CW signal may be generated. The mean power of the CW signal is determined, which directly corresponds to the amplitude of the CW signal. Thus, the amplitude of the CW signal can be set directly based on a measurement of the average power of the CW signal.

After the amplitude of the CW signal is set, a further CW signal is generated and the mean power is determined. The amplitude of the further CW signal may be set based on the determined mean power of the two CW signals. Alternatively, the first CW signal generated may be switched off such that the amplitude of the further CW signal can be set based on a measurement of the mean power of the further CW signal alone.

For example, if both CW signals shall have the same amplitude, the mean power of the two CW signals combined should be double the mean power of the signal CW signal determined before.

After the amplitudes of the two CW signals have been set, the steps described above are repeated for a third CW signal, i.e. the amplitude of the third CW signal is set based on a measurement of the mean power of the three CW signals and/or based on a measurement of the mean power of the third CW signal.

After the amplitudes of the CW signals have been set, the phase of the at least one CW signal may be varied as described above, i.e. the phase relation of the three CW signals is set based on the measurement of the ratio of the peak power and the mean power.

According to another aspect of the present invention, a peak-to-average power ratio of the multi-tone signal is minimized or maximized. In other words, the ratio of the peak power and the mean power may be the peak-to-average power. Put differently, the ratio of the peak power and the mean power may be equal to the square of the crest factor of the multi-tone signal generated by the signal generating device.

In an embodiment of the present invention, the at least one predetermined reference plane corresponds to an input of a device under test, an output of a device under test, a reflection region associated with an input of a device under test, a reflection region associated with an output of a device under test, an input of a signal analyzer, and/or an output of the signal generating device. In general, different reference planes may be associated with different use cases of the method of performing the vector characterization based on the scalar measurement. This is described in more detail below.

Therein and in the following, the term "reflection region associated with an input" is understood to denote a portion of electric circuitry and/or cabling that is located upstream of the respective input of the device under test. Accordingly, if the multi-tone signal is partially reflected at the input of the device under test, the reflected portion of the multi-tone signal may propagate to the reflection region associated with the input.

Particularly, a directional coupler may be provided upstream of the input, wherein the directional coupler may be configured to forward the multi-tone signal to the input of the device under test. The directional coupler may further be configured to isolate a reflected portion of the multi-tone signal, i.e. a portion of the multi-tone signal that is reflected at the input of the device under test.

A measurement of the reflected portion may also be called a measurement of an S11 scattering parameter of the device under test.

Moreover, the term "reflection region associated with an output" is understood to denote a portion of electric circuitry and/or cabling that is located downstream of the respective output of the device under test. Accordingly, if the multi-tone signal is forwarded to the output and is partially reflected at the output of the device under test, the reflected portion of the multi-tone signal may propagate to the reflection region associated with the output.

Particularly, a directional coupler may be provided downstream of the output, wherein the directional coupler may be configured to forward the multi-tone signal to the output of the device under test. The directional coupler may further be configured to isolate a reflected portion of the multi-tone signal, i.e. a portion of the multi-tone signal that is reflected at the output of the device under test.

A measurement of the reflected portion may also be called a measurement of a S22 scattering parameter of the device under test.

In a further embodiment of the present invention, the signal generating device is calibrated and/or set by varying the phase of the at least one of the at least three CW signals. For certain types of measurements, the CW signals of the multi-tone signal need to be "in phase" or "opposite in phase", as described above. By varying the phase of the least one of the at least three CW signals, the signal generating device can be calibrated and/or set such that the signal generating device generates a desired multi-tone signal, namely the first multi-tone signal.

Of course, the amplitudes of the at least three CW signals may be set as described above in order to calibrate the signal generating device and/or in order to generate a desired multi-tone signal, namely the first multi-tone signal.

In fact, the signal generating device can be calibrated and/or set such that the first multi-tone signal has desired properties, i.e. desired phase relations between the at least three CW signals, particularly the desired amplitudes of the at least three CW signals, at the at least one predetermined reference plane described above.

For example, if the at least one predetermined reference plane corresponds to an input of a device under test, the signal generating device can be calibrated and/or set such that the device under test receives the first multi-tone signal with properties that are suitable for testing the device under test, irrespective of any further electronic components and/or cabling that may be provided between the signal generating device and the device under test. In other words, the influence of the further electronic components and/or cabling located between the signal generating device and the device under test may be compensated.

If the at least one predetermined reference plane corresponds to the output of the signal generator device, the first multi-tone signal generated by the signal generating device has the desired properties directly at the output of the signal generating device.

According to a further aspect of the present invention, steps a) to c) are performed at at least two different predetermined reference planes, particularly at the input of the device under test and at the output of the device under test, at the input of the device under test and in the reflection region associated with the input of the device under test, or at the output of the device under test and in the reflection region associated with the output of the device under test.

By repeating steps a) to c) at two different predetermined reference planes, certain properties of a device under test can be tested. In fact, information/data is obtained in a combined manner, wherein the fused data/information provides a deeper insight, allowing further characterizations.

For example, if the two iterations of steps a) to c) are performed at the input and at the output of the device under test, transfer characteristics of the device under test can be measured or rather determined based on the two iterations of steps a) to c). Particularly, a S12 scattering parameter of the device under test may be determined based on the two iterations of steps a) to c), if the multi-tone signal is forwarded to the input of the device under test.

Alternatively or additionally, a S21 scattering parameter of the device under test may be determined based on the two iterations of steps a) to c), if the multi-tone signal is forwarded to the output of the device under test.

If the two iterations of steps a) to c) are performed at the input of the device under test and in the reflection region associated with the input of the device under test, a S11 scattering parameter of the device under test may be determined based on the two iterations of steps a) to c).

If the two iterations of steps a) to c) are performed at the output of the device under test and in the reflection region associated with the output of the device under test, a S22 scattering parameter of the device under test may be determined based on the two iterations of steps a) to c).

Particularly, transfer characteristics of the device under test are determined based on a comparison of the two iterations of steps a) to c) at the at least two different predetermined reference planes. As described above, the two iterations of steps a) to c) may be performed at the input and at the output of the device under test. The device under test may alter the multi-tone signal forwarded to the input of the device under test in amplitude and/or phase. A corresponding output signal of the device under test may be described in frequency domain as the multi-tone signal forwarded to the input of the device under test times the transfer function of the device under test. Thus, the adjustments of the phases (and optionally the amplitudes) that are necessary at the output of the device under test to obtain the first multi-tone signal again can be used in order to determine the transfer function of the device under test at least for the at least three frequencies of the at least three CW signals.

Accordingly, the two iterations of steps a) to c) may be performed for different sets of frequencies of the CW signals in order to determine the transfer function of the device under test in a predetermined frequency range.

According to an aspect of the present invention, the at least three CW signals are equally spaced in frequency domain, particularly wherein a frequency spacing of the at least three CW signals is as small as possible. It has turned out that CW signals that are equally spaced in frequency domain are most suitable for performing the measurements described above.

The smallest possible frequency spacing may depend on a frequency resolution of the signal generating device, particularly of the vector signal generator. In other words, the frequency spacing of the at least three CW signals being as small as possible may denote the smallest possible frequency spacing that can be generated by the signal generating device, particularly by the vector signal generator.

By choosing the smallest possible frequency spacing, dispersion effects within the measurement setup can be neglected without sacrificing measurement precision.

In a further embodiment of the present invention, the phase of one of the at least three CW signals of the first set of CW signals is shifted by 180°, thereby obtaining a second multi-tone signal comprising a second set of CW signals. If the first multi-tone signal comprising the first set of CW signals has a maximum ratio of the peak power to the mean power, then the second multi-tone signal comprising the second set of CW signals should have a minimum ratio of the peak power to the mean power, and vice versa. Thus, by shifting the phase of one of the at least three CW signals by 180°, the proper phase-alignment of the at least three CW signals can be checked.

According to an aspect of the present invention, the mean power of the second multi-tone signal and the peak power of the second multi-tone signal corresponding to the second set of CW signals are determined. Particularly, a ratio of the peak power and the mean power of the second multi-tone signal is compared with a maximum or minimum of the ratio of the peak power and the mean power. If the first multi-tone signal comprising the first set of CW signals has a maximum ratio of the peak power to the mean power, then the second multi-tone signal comprising the second set of CW signals should have a minimum ratio of the peak power to the mean power, and vice versa. Thus, by shifting the phase of one of the at least three CW signals by 180°, the proper phase-alignment of the at least three CW signals can be checked by comparing the ratio of the peak power and the mean power of the second multi-tone signal with the maximum or minimum of the ratio of the peak power and the mean power.

According to another aspect of the present invention, the first multi-tone signal is processed by means of at least one further electronic component before the mean power and the peak power are determined. Particularly, the at least one further electronic component comprises at least one of a filter, an amplifier, a frequency converter, a digital-to-analog converter, a signal conductor, and a directional coupler. In general, the at least one further component may have a transfer function that is different from unity such that the phases (and optionally the amplitudes) of the at least three CW signals of the first multi-tone signal are altered by the at least one further electronic component. Thus, the influence of or rather imperfections introduced by the at least one further electronic component can be compensated by varying the phase (and optionally amplitude) of the at least one CW signal downstream of the at least one further electronic component.

In an embodiment of the present invention, at least one further CW signal is added to the first set of CW signals, thereby obtaining an extended multi-tone signal comprising at least four CW signals. Particularly, steps b) and c) are repeated for the extended multi-tone signal. Thus, a custom frequency comb having desired properties may be generated by iteratively adding further CW signals and performing steps b) and c) for the resulting extended multi-tone signal.

The amplitude of the at least one further CW signal may be set analogously as described above with respect to the at least three CW signals, i.e. the amplitude of the at least one further CW signal is set based on a measurement of the mean power of the at least three four CW signals and/or based on a measurement of the mean power of the at least one further CW signal alone.

The resulting frequency comb may be used in order to test a device under test and/or to calibrate a vector signal analyzer.

The phases (and optionally the amplitudes) of the at least four CW signals may be added to the database, such that the corresponding settings of the signal generating device are saved in the database.

A frequency spacing of the first set of CW signals may be increased, thereby obtaining a multi-tone signal comprising a set of CW signals having a larger frequency spacing than the first set of CW signals. Any of the measurements described above may be repeated with the multi-tone signal having the larger frequency spacing, such that additional information on the device under test, particularly on the transfer function and/or scattering parameters of the device under test, and/or additional information for calibrating and/or setting the signal generating device is obtained.

For example, the CW signal having a frequency in between the other two CW signals may be relocated to a frequency being higher than or lower than the other two CW signals, particularly wherein an equal frequency spacing between the CW signals is maintained. The phase (and optionally the amplitude) of the relocated CW signal may then be varied according to steps b) and c).

The phases (and optionally the amplitudes) of the at least three CW signals (with the relocated CW signal) may be added to the database, such that the corresponding settings of the signal generating device are saved in the database.

Particularly, a center frequency of the first set of CW signals is varied, thereby obtaining a frequency-modified set of CW signals, and wherein the step of determining the mean power and the peak power as well as the step of varying the phase is repeated for the frequency-modified set of CW signals. Any of the measurements described above may be repeated with the frequency-modified set of CW signals, such that additional information on the device under test, particularly on the transfer function and/or scattering parameters of the device under test, and/or additional information for calibrating and/or setting the signal generating device is obtained.

The phases (and optionally the amplitudes) of the at least three CW signals associated with the frequency-modified set of CW signals may be added to the database, such that the corresponding settings of the signal generating device are saved in the database.

According to the invention, the problem further is solved by an electronic system for performing a vector characterization based on a scalar measurement according to claim 16.

The electronic system is configured to perform the method of performing a vector characterization based on a scalar measurement described above.

Regarding the advantages and further properties of the electronic system, reference is made to the explanations given above with respect to the method of performing a vector characterization based on a scalar measurement, which also hold for the electronic system and vice versa.

For instance, the signal generating device is configured to vary amplitudes and phases of the at least three CW signals.

The foregoing aspects and many of the attendant advantages of the claimed subject matter will become more readily appreciated as the same become better understood by reference to the following detailed description, when taken in conjunction with the accompanying drawings, wherein:

- Figure 1 schematically shows an electronic system according to a first embodiment of the present invention;

- Figure 2 schematically shows an electronic system according to a second embodiment of the present invention;

- Figure 3 schematically shows an electronic system according to a third embodiment of the present invention;

- Figure 4 shows a flow chart of a method of performing a vector characterization based on a scalar measurement according to the present invention;

- Figures 5 (a) to (d) show different plots of the power of a multi-tone signal;

- Figures 6 (a) to (f) show several diagrams illustrating individual steps of the method of Figure 4; and

- Figures 7 (a) to (g) show further diagrams illustrating individual steps of the method of Figure 4.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

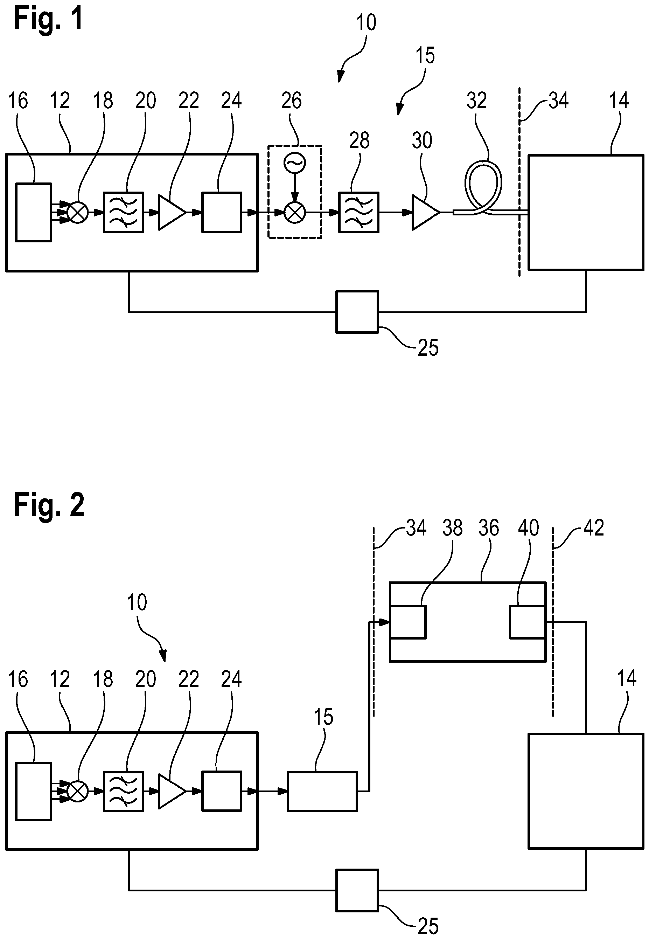

Figure 1 schematically shows an electronic system 10 for performing a vector characterization based on a scalar measurement.

The electronic system 10 comprises a signal generating device 12, a scalar measurement device 14, and further electronic components 15 interconnected between the signal generating device 12 and the scalar measurement device 14.

In general, the signal generating device 12 is configured to generate a multi-tone signal comprising at least three different CW signals, wherein the at least three different CW signals have center frequencies that are pairwise different from each other.

Particularly, the signal generating device 12 may be established as a vector signal generator.

The signal generating device 12 is configured to vary the phases of the at least three different CW signals, such that each of the at least three different CW signals can be generated with a predetermined phase.

Optionally, the signal generating device 12 may be configured to vary the amplitudes of the at least three different CW signals, such that each of the at least three different CW signals can be generated with a predetermined amplitude.

The signal generating device 12 may comprise an arbitrary waveform generator 16 that is configured to generate the at least three CW signals, and an additive mixer 18 that is configured to sum the at least three CW signals, thereby obtaining the multi-tone signal.

The signal generating device 12 may further comprise a bandpass filter 20, an amplifier 22, and/or a digital-to-analog converter 24.

It is noted that the additive mixer 18, the bandpass filter 20, the amplifier 22, and/or the digital-to-analog converter 24 may also be provided separately from the signal generating device 12, i.e. outside of the signal generating device 12.

The scalar measurement device 14 is configured to determine a mean power and a peak power of any signal forwarded to the scalar measurement device 14.

Moreover, the scalar measurement device 14 is configured to determine a ratio of the mean power and the peak power of the respective signal.

Therein, the term "mean power" is understood to denote an average power. For example, the mean power may be a root mean square power. However, other averaging techniques may also be used.

The ratio of the peak power and the mean power may be the peak-to-average power. Put differently, the ratio of the peak power and the mean power may be equal to the square of the crest factor of the multi-tone signal generated by the signal generating device 12.

In the embodiment shown in Figure 1, the electronic system 10 further comprises a controller 25 that is connected to both the signal generating device 12 and the scalar measurement device 14.

In general, the controller 25 is configured to control the signal generating device 12 based on an output of the scalar measurement device 14, particularly based on the mean power, the peak power, and/or the ratio of the peak power and the main power determined.

For example, the controller 25 may be established as a personal computer, laptop, smartphone, tablet, or as any other smart device with suitable software.

It is noted that the controller 25 may also be integrated into the signal generating device 12 and/or the scalar measurement device 14.

In the embodiment shown in Figure 1, the further electronic components 15 comprise a frequency converter 26, a bandpass filter 28, an amplifier 30, and a signal conductor 32.

In general, the frequency converter 26 is configured to adapt the frequencies of the multi-tone signal in a predetermined manner.

For example, the frequency converter 26 may be configured to multiplicatively mix the multi-tone signal generated by the signal generating device 12 with a sine-shaped signal having a predetermined frequency, thereby generating two "copies" of the multi-tone signal. Therein, one copy has higher frequencies than the original multi-tone signal, while the other copy has lower frequencies than the original multi-tone signal.

The resulting frequency-converted multi-tone signal may then be appropriately filtered by means of the bandpass filter 28 in order to isolate the desired copy of the multi-tone signal.

The signal conductor 32 may be established as any suitable type of electrical connection, particularly as a suitable type of cable.

The scalar measurement device 14 is connected to the further electronic components 15 downstream of the further electronic components 15 such that the scalar measurement device 14 is configured to perform measurements at a first predetermined reference plane 34. This will be described in more detail hereinafter.

Figure 2 shows a second embodiment of the electronic system 10, wherein only the differences compared to the first embodiment of the electronic system 10 described above are explained in the following.

In the embodiment shown in Figure 2, the electronic system 10 comprises a device under test 36 that is connected to the signal generating device 12 downstream of the further electronic components 15.

More precisely, an input 38 of the device under test 36 is connected to the signal generating device 12 at the first predetermined reference plane 34.

The device under test 36 further comprises an output 40 that corresponds to a second predetermined reference plane 42.

In the embodiment shown in Figure 2, the scalar measurement device 14 is connected to the output 40 of the device under test 36 such that the scalar measurement device 14 can perform measurements at the second predetermined reference plane 42.

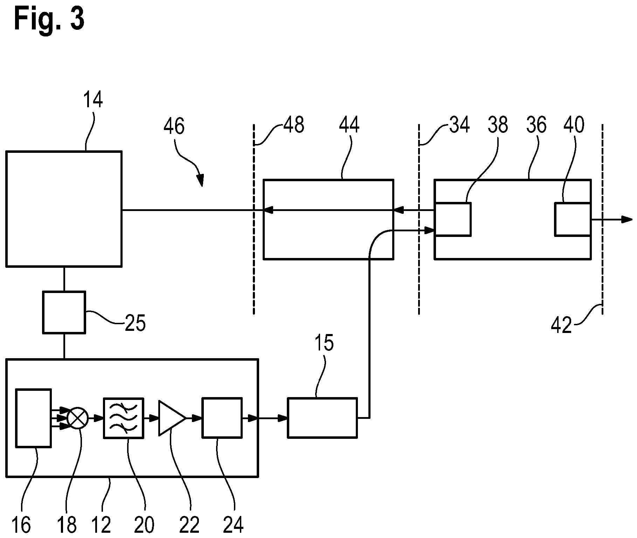

Figure 3 shows a third embodiment of the electronic system 10, wherein only the differences compared to the first and second embodiments of the electronic system 10 described above are explained in the following.

In the embodiment shown in Figure 3, the electronic system 10 further comprises a directional coupler 44 that is connected to the signal generating device 12 downstream of the further electronic components 15.

The directional coupler 44 is interconnected between the further electronic components 15 and the input 38 of the device under test 36.

Typically, the directional coupler 44 has three ports.

The directional coupler 44 is configured to forward the multi-tone signal generated by the signal generating device 12 to the device under test 36.

Moreover, the directional coupler 44 is configured to forward a reflected portion of the multi-tone signal that is reflected at the input 38 to a reflection region 46.

In the embodiment shown in Figure 3, the scalar measurement device 14 is connected to the directional coupler 44 in the reflection region 46 such that the scalar measurement device 14 can perform measurements at a third predetermined reference plane 48 that is located in the reflection region 46.

Accordingly, the directional coupler 44 has an input port associated with the signal generating device 12, a transmitted port associated with the device under test 36 and a coupled port associated with the scalar measurement device 14, which is used for forwarding the reflected portion of the multi-tone signal.

The electronic system 10 is configured to perform a method of performing a vector characterization based on a scalar measurement. In fact, the electronic system 10 can be used for different types of vector characterizations that are described in the following.

## Calibration and/or setting of the signal generating device

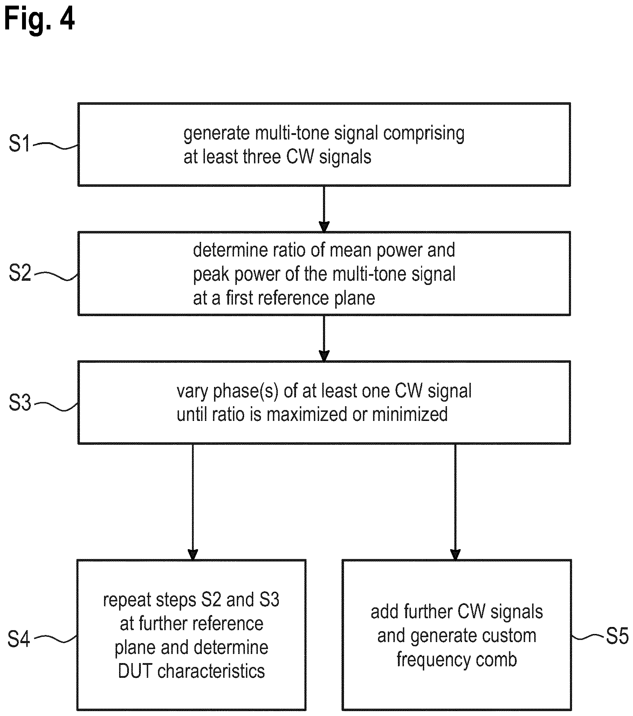

A first embodiment of the method is described in the following with reference to Figures 1 and 4.

A multi-tone signal comprising at least three CW signals is generated by means of the signal generating device 12 (step S1).

Without restriction of generality, the case of the multi-tone signal comprising exactly three CW signals is described in the following.

The three CW signals have a certain frequency spacing, such that each of the three CW signals has a different center frequency.

The three CW signals may be equally spaced in frequency domain, i.e. the frequency difference between the CW signal having the lowest frequency and the CW signal having the middle frequency is the same as the frequency difference between the CW signal having the middle frequency and the CW signal having the highest frequency.

Particularly, a frequency spacing of the at least three CW signals is as small as possible.

The smallest possible frequency spacing may depend on a frequency resolution of the signal generating device 12, particularly of the vector signal generator. In other words, the frequency spacing of the three CW signals being as small as possible may denote the smallest possible frequency spacing that can be generated by the signal generating device 12, particularly by the vector signal generator.

The multi-tone signal generated by the signal generating device 12 is processed by means of the further electronic components 15 and forwarded to the scalar measurement device 14.

A mean power of the multi-tone signal and a peak power of the multi-tone signal, as well as a ratio of the mean power and the peak power are determined by means of the scalar measurement device 14 at the first predetermined reference plane 34, as described above (step S2).

A phase of at least one of the three CW signals is varied by means of the signal generating device 12 such that the ratio of the peak power and the mean power is minimized or maximized, thereby obtaining a first multi-tone signal comprising a first set of CW signals (step S3).

More precisely, the phases of the three CW signals can be set to be "in phase" by varying the phase of the at least one of the three CW signals until the ratio of the peak power and the mean power reaches its maximum.

The phases of the three CW signals can be set to be "opposite in phase" or "anti-phase" by varying the phase of the at least one of the three CW signals until the ratio of the peak power and the mean power reaches its minimum.

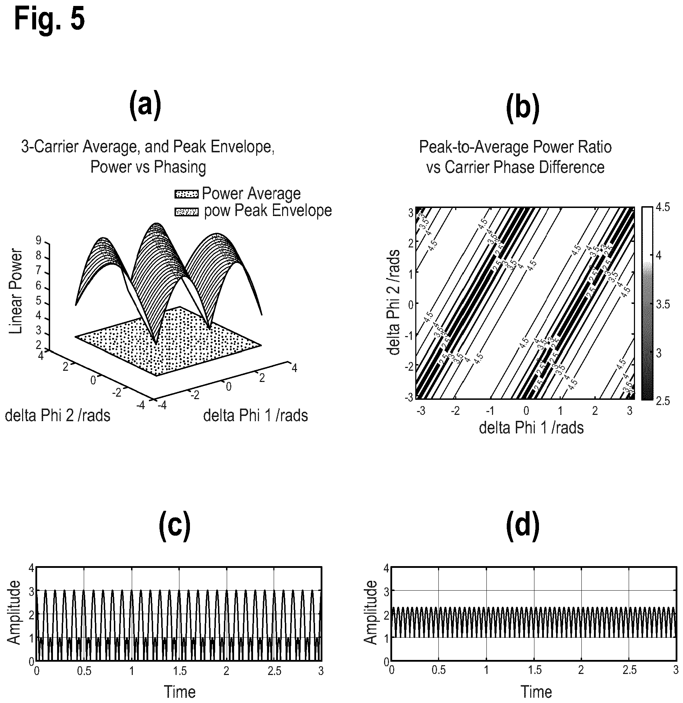

This is illustrated in Figures 5(a) to 5(d). Figure 5(a) shows the dependency of the mean power ("powAverage" in Figure 5(a)) and of the peak power ("powPeakEnvelope" in Figure 5(b)) of a multi-tone signal comprising three CW signals on the relative phases of the CW signals.

Figure 5(b) shows the dependency of the ratio of the peak power and the mean power on the relative phases of the CW signals.

Figure 5(c) shows a resulting multi-tone signal after maximizing the ratio of the peak power and the mean power, wherein the amplitude of the resulting multi-tone signal is plotted against time.

Figure 5(d) shows a resulting multi-tone signal after minimizing the ratio of the peak power and the mean power, wherein the amplitude of the resulting multi-tone signal is plotted against time.

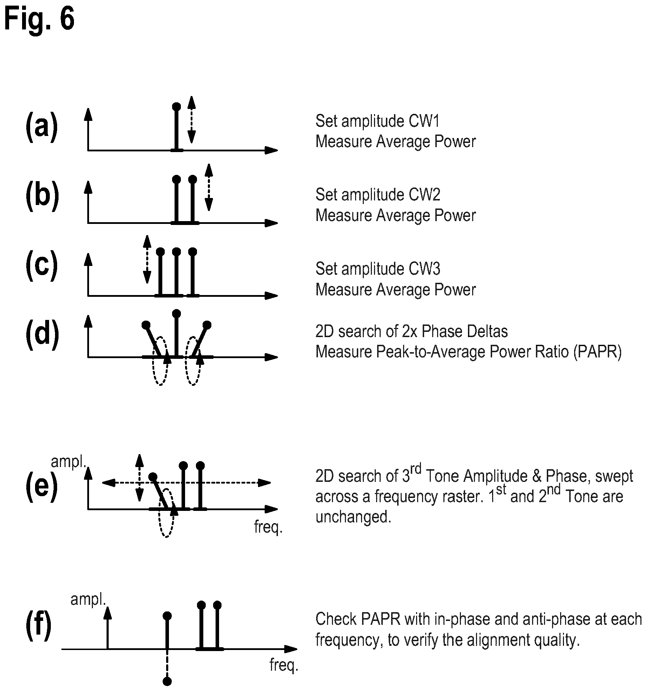

As illustrated in Figure 6, steps S1 to S3 may also performed in an iterative manner.

First, only a single CW signal is generated with a predetermined amplitude and the mean power is measured, cf. Figure 6(a). More precisely, the amplitude of the single CW signal may be set based on the measured mean power.

The mean power of the single CW signal directly corresponds to the amplitude of the single CW signal. Thus, the amplitude of the CW signal can be set directly based on a measurement of the average power of the CW signal.

Afterwards, a second CW signal having a predetermined amplitude is added, and the mean power of the resulting multi-tone signal is measured, cf. Figure 6(b). More precisely, the amplitude of the second CW signal may be set based on the measured mean power.

The amplitude of the second CW signal may be set based on the measured mean power of the two CW signals. Alternatively, the first CW signal generated may be switched off such that the amplitude of the second CW signal can be set based on a measurement of the mean power of the second CW signal alone.

For example, if both CW signals shall have the same amplitude, the mean power of the two CW signals combined should be double the mean power of the signal CW signal determined before.

Then, a third CW signal having a predetermined amplitude is added to the multi-tone signal, and the mean power of the resulting multi-tone signal is measured, cf. Figure 6(c). More precisely, the amplitude of the third CW signal may be set based on the measured mean power.

The amplitude of the third CW signal may be set based on the measured mean power of the three CW signals. Alternatively, the first CW signal and the second CW signal generated may be switched off such that the amplitude of the third CW signal can be set based on a measurement of the mean power of the third CW signal alone.

The phase(s) of one or two CW signals of the three CW signals are varied until the ratio of the peak power and the mean power of the multi-tone signal is minimized or maximized, cf. Figure 6(d).

Alternatively or additionally to varying the phase of one of the three CW signals, the center frequency of the respective CW signal may be varied as well , cf. Figure 6(e).

As is illustrated in Figure 6(f), the phase of one of the three CW signals of the first set of CW signals may be shifted by 180° in order to check the proper phase-alignment of the three CW signals, thereby obtaining a second multi-tone signal comprising a second set of CW signals.

If the first multi-tone signal comprising the first set of CW signals has a maximum ratio of the peak power to the mean power, then the second multi-tone signal comprising the second set of CW signals should have a minimum ratio of the peak power to the mean power, and vice versa.

If this is not the case, step S3 may be repeated in order to find the correct phase alignment for the three CW signals.

By performing steps S1 to S3 described above, the signal generating device 12 is calibrated and/or set such that the generated first multi-tone signal has desired properties at the first predetermined reference plane 34.

Moreover, the influence of the further electronic components 15 located between the signal generating device 12 and the scalar measurement device 14 may be compensated.

Optionally, the variation of the phase may be performed by guessing the phase error from the determined ratio of the peak power and the mean power, and/or by using a numerical method.

The phases (and optionally the amplitudes) of the at least three CW signals may be added to a database, such that the corresponding settings of the signal generating device 12 are saved in the database.

For future measurements and/or for comparison purposes, the signal generating device 12 may access the database and the corresponding settings may be loaded from the database into the signal generating device 12, such that the signal generating device does not have to be calibrated again,

Thus, the database may be a lookup table with a plurality of possible settings of the signal generating device 12, wherein different settings may correspond to different first sets of CW signals, i.e. to different multi-tone signals comprising different first sets of CW signals.

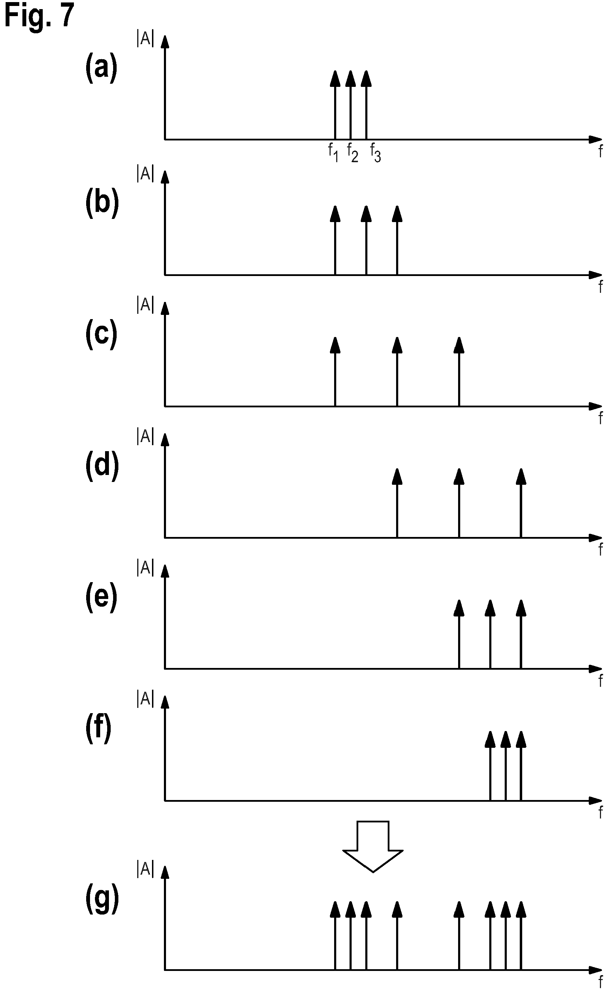

In fact, further calibration data or rather possible settings of the signal generating device 12 may be obtained as described in the following with reference to Figure 7.

Figure 7 (a) shows the multi-tone signal comprising the three CW signals obtained by performing the steps described above.

As is illustrated in Figures 7 (a) and (b), the CW signal having a frequency in between the other two CW signals is relocated to a frequency being higher than or lower than the other two CW signals, particularly wherein an equal frequency spacing between the CW signals is maintained.

In other words, if the three CW signals have frequencies $f_1$, $f_2$ and $f_3$, the CW signal having frequency $f_2$ may be moved to frequency $f_2' = 2f_3 - f_1$ or to $f_2' = 2f_1 - f_3$.

The phase (and optionally the amplitude) of the relocated CW signal may then be varied as described above with respect to steps S1 to S3.

The corresponding phase (and optionally amplitude) settings for the signal generating device 12 may be added to the database.

As is illustrated in Figures 7 (c) and (d), the CW signal having the highest or the lowest frequency may be relocated to a frequency being lower than or higher than the other two CW signals, respectively, particularly wherein an equal frequency spacing between the CW signals is maintained.

In other words, if the three CW signals have frequencies $f_1$, $f_2$ and $f_3$, the CW signal having frequency $f_1$ may be moved to frequency $f_1' = 2f_3 - f_2$, or the CW signal having frequency $f_3$ may be moved to $f_3' = 2f_1 - f_2$.

The phase (and optionally the amplitude) of the relocated CW signal may then be varied as described above with respect to steps S1 to S3.

The corresponding phase (and optionally amplitude) settings for the signal generating device 12 may be added to the database.

As is illustrated in Figures 7 (d) to (f), the CW signal having the highest or the lowest frequency may be relocated to a between the other two CW signals, respectively, particularly wherein an equal frequency spacing between the CW signals is maintained.

In other words, if the three CW signals have frequencies $f_1$, $f_2$ and $f_3$, the CW signal having frequency $f_1$ may be moved to frequency $f_1' = (f_3 + f_2)/2$, or the CW signal having frequency $f_3$ may be moved to $f_3' = (f_1 + f_2)/2$.

The phase (and optionally the amplitude) of the relocated CW signal may then be varied as described above with respect to steps S1 to S3.

The corresponding phase (and optionally amplitude) settings for the signal generating device 12 may be added to the database.

By performing the steps described above with respect to Figures 7 (a) to (f), a plurality of settings for the signal generating device 12 is obtained, i.e. settings that are suitable for generating each of the different CW signals.

This is illustrated in Figure 7 (g), which shows an exemplary set of CW signals that can be generated by the signal generating device 12 after the calibration steps described above are performed.

Particularly, an arbitrary subset of the CW signals illustrated in Figure 7 (g) may be generated at the same time, i.e. a multi-tone signal comprising an arbitrary subset of at least three of the CW signals.

## Measurement of transfer characteristics

A second embodiment of the method is described in the following with reference to Figures 2 and 4.

First, steps S1 to S3 described above are performed at the first predetermined reference plane 34 that is associated with the input 38 of the device under test 36.

The first multi-tone signal is forwarded to the input 38 of the device under test 36 and processed by the device under test 36, thereby obtaining an output signal at the output 40 of the device under test 36.

In general, the device under test 36 alters the amplitudes and/or phases of the first set of CW signals.

The output signal of the device under test 36 may be described in frequency domain as the first multi-tone signal times the transfer function of the device under test 36.

The output signal of the device under test 36 is forwarded to the scalar measurement device 14.

Steps S2 and S3 described above are repeated for the output signal, i.e. at least the phase of at least one of the three CW signals of the output signal is varied until the ratio of the peak power and the mean power of the output signal of the device under test 36 is minimized or maximized. Transfer characteristics of the device under test 36 are determined based on a comparison of the two iterations of steps S2 and S3 at the input 38 (i.e. at the first predetermined reference plane 34) and at the output 40 (i.e. at the second predetermined reference plane 42) of the device under test 36.

In general, the adjustments of the phases (and optionally the amplitudes) of the CW signals that are necessary at the output 40 of the device under test 36 in order to obtain the first multi-tone signal again can be used in order to determine the transfer function of the device under test 36 at least for the three frequencies of the three CW signals.

Alternatively or additionally to the transfer function, further transfer characteristics of the device under test 36 may be determined, for example gain, phase shift, group delay, etc.

The two iterations of steps S2 and S3 may be performed for different sets of frequencies of the CW signals in order to determine the transfer function of the device under test 36 in a predetermined frequency range.

Alternatively or additionally, the frequency spacing of the CW signals of the multi-tone signal may be varied, particularly increased.

Optionally, the additional steps described above with respect to Figures 7 (a) to (g) may be repeated for the output signal, such that the comparison is performed for a portion of the database or for the complete database.

It is noted that the measurement of the transfer function of the device under test 36 corresponds to the measurement of the S12 scattering parameter of the device under test 36.

Of course, the S21 scattering parameter may be determined analogously, namely by connecting the signal generating device 12 to the output 40 of the device under test 36, performing the first iteration of steps S2 and S3 at the output 40 of the device under test 36, and performing the second iteration of steps S2 and S3 at the input 38 of the device under test 36.

## Measurement of reflectivity characteristics

A third embodiment of the method is described in the following with reference to Figures 3 and 4.

First, steps S1 to S3 described above are performed at the first predetermined reference plane 34 that is associated with the input 38 of the device under test 36.

A portion of the multi-tone signal forwarded to the input 38 of the device under test 36 is reflected at the input 38.

The reflected portion of the multi-tone signal is isolated by the directional coupler 44 and forwarded to the scalar measurement device 14 that is located in the reflection region 46.

Steps S2 and S3 described above are repeated for the reflected portion of the multi-tone signal, i.e. at least the phase of at least one of the three CW signals of the reflected portion of the multi-tone signal is varied until the ratio of the peak power and the mean power of the output signal of the device under test 36 is minimized or maximized (step S4).

In general, the adjustments of the phases (and optionally the amplitudes) of the CW signals that are necessary at the third predetermined reference plane 48 in order to obtain the first multi-tone signal again can be used in order to determine reflectivity characteristics of the device under test 36 at least for the three frequencies of the three CW signals.

The two iterations of steps S2 and S3 may be performed for different sets of frequencies of the CW signals in order to determine the reflectivity characteristics of the device under test 36 in a predetermined frequency range.

Alternatively or additionally, the frequency spacing of the CW signals of the multi-tone signal may be varied, particularly increased.

Optionally, the additional steps described above with respect to Figures 7 (a) to (g) may be repeated at the third predetermined reference plane 48, such that the comparison is performed for a portion of the database or for the complete database.

It is noted that the measurement of the reflectivity characteristics of the device under test 36 may comprise the measurement of the S11 scattering parameter of the device under test 36.

Of course, the S22 scattering parameter may be determined analogously, namely by connecting the signal generating device 12 to the output 40 of the device under test 36 via the directional coupler 44. The first iteration of steps S2 and S3 is performed at the output 40 of the device under test 36, and the second iteration of steps S2 and S3 is performed in a reflection region associated with the output 40.

**Custom frequency combs**

A fourth embodiment of the method is described in the following with reference to Figures 1 and 4.

First, steps S1 to S3 described above are performed at the first predetermined reference plane 34.

At least one further CW signal is added to the first set of CW signals, thereby obtaining an extended multi-tone signal comprising at least four CW signals (step S5).

Steps S2 and S3 described above are then repeated for the extended multi-tone signal.

Afterwards, at least one further CW signal may be added to the at least four CW signals, and steps S2 and S3 may be repeated again for the resulting multi-tone signal.

Accordingly, a custom frequency comb can be generated iteratively by adding further CW signals and performing steps S2 and S3 in each iteration.

The resulting custom frequency comb may be used in order to test the device under test 36 and/or to calibrate a vector signal analyzer and/or for any other possible application requiring a frequency comb.

It is noted that a custom frequency comb can also be obtained by performing the steps described above with respect to Figures 7 (a) to (g), and by generating a certain subset of the CW signals obtained during these steps, i.e. a certain subset of the CW signals illustrated in Figure 7 (g).

Certain embodiments disclosed herein, particularly the respective module(s), units and/or devices, utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

**Claims**

1. A method of performing a vector characterization based on a scalar measurement, the method comprising the following steps:

 a) generating a multi-tone signal by means of a signal generating device (12), wherein the multi-tone signal comprises at least three continuous-wave (CW) signals, the at least three CW signals having a certain frequency spacing such that each of the three CW signals has a different center frequency, and wherein the signal generating device (12) is configured to vary phases of the at least three CW signals;

 b) determining a mean power of the multi-tone signal and a peak power of the multi-tone signal by means of a scalar measurement device (14), wherein the mean power and the peak power are measured at at least one predetermined reference plane (34, 42, 48); and

 c) varying a phase of at least one of the at least three CW signals by means of the signal generating device (12) such that a ratio of the peak power and the mean power is minimized or maximized, thereby obtaining a first multi-tone signal comprising a first set of CW signals;

 wherein the method is used in order to calibrate a signal generator, to perform measurements of transfer characteristics and/or reflectivity characteristics of a device under test (36), and/or to generate a frequency comb with predefined properties.

2. The method of claim 1, wherein the signal generating device (12) is a vector signal generator.

3. The method according to any one of the preceding claims, wherein the signal generating device (12) is configured to vary amplitudes of the at least three CW signals, particularly wherein the amplitudes of the at least three CW signals are set based on the mean power.

4. The method according to any one of the preceding claims, wherein a peak-to-average power ratio of the multi-tone signal is minimized or maximized.

5. The method according to any one of the preceding claims, wherein the at least one predetermined reference plane (34, 42, 48) corresponds to an input (38) of a device under test (36), an output (40) of a device under test (36), a reflection region (46) associated with an input (38) of a device under test (36), a reflection region associated with an output (40) of a device under test (36), an input of a signal analyzer, and/or an output of the signal generating device (12).

6. The method according to claim 5, wherein the signal generating device (12) is calibrated and/or set by varying the phase of the at least one of the at least three CW signals.

7. The method according to claim 5 or 6, wherein steps a) to c) are performed at at least two different predetermined reference planes (34, 42, 48), particularly at the input (38) of the device under test (36) and at the output (40) of the device under test (36), at the input (38) of the device under test (36) and in the reflection region (46) associated with the input (38) of the device under test (36), or at the output (40) of the device under test (36) and in the reflection region associated with the output (40) of the device under test (36).

8. The method according to claim 7, wherein transfer characteristics of the device under test (36) are determined based on a comparison of the two iterations of steps a) to c) at the at least two different predetermined reference planes (34, 42, 48).

9. The method according to any one of the preceding claims, wherein the at least three CW signals are equally spaced in frequency domain, particularly wherein a frequency spacing of the at least three CW signals is as small as possible.

10. The method according to any one of the preceding claims, wherein the phase of one of the at least three CW signals of the first set of CW signals is shifted by 180°, thereby obtaining a second multi-tone signal comprising a second set of CW signals.

11. The method of claim 10, wherein the mean power of the second multi-tone signal and the peak power of the second multi-tone signal corresponding to the second set of CW signals are determined, particularly wherein a ratio of the peak power and the mean power of the second multi-tone signal is compared with a maximum or minimum of the ratio of the peak power and the mean power.

12. The method according to any one of the preceding claims, wherein the first multi-tone signal is processed by means of at least one further electronic component (15) before the mean power and the peak power are determined, particularly wherein the at least one further electronic component comprises at least one of a filter (28), an amplifier (30), a frequency converter (26), a digital-to-analog converter, a signal conductor (32), and a directional coupler (44).

13. The method according to any one of the preceding claims, wherein at least one further CW signal is added to the first set of CW signals, thereby obtaining an extended multi-tone signal comprising at least four CW signals, particularly wherein steps b) and c) are repeated for the extended multi-tone signal.

14. The method according to any one of the preceding claims, wherein a frequency spacing of the first set of CW signals is increased, thereby obtaining a multi-tone signal comprising a set of CW signals having a larger frequency spacing than the first set of CW signals.

15. The method according to any one of the preceding claims, wherein a center frequency of the first set of CW signals is varied, thereby obtaining a frequency-modified set of CW signals, and wherein the step of determining the mean power and the peak power as well as the step of varying the phase is repeated for the frequency-modified set of CW signals.

16. An electronic system for performing a vector characterization based on a scalar measurement, the electronic system (10) comprising a signal generating device (12), a scalar measurement device (14), and a controller (25),

> wherein the signal generating device (12) is configured to generate a multi-tone signal, wherein the multi-tone signal comprises at least three continuous-wave (CW) signals, the at least three continuous-wave signals having a certain frequency spacing such that each of the three CW signals has a different center frequency, wherein the signal generating device (12) is configured to vary phases of the at least three CW signals,

wherein the scalar measurement device (14) is configured to determine a mean power of the multi-tone signal and a peak power of the multi-tone signal at at least one predetermined reference plane (34, 42, 48),

wherein the controller (25) is configured to control the signal generating device (12) to vary a phase of at least one of the at least three CW signals such that a ratio of the peak power and the mean power is minimized or maximized, thereby obtaining a first multi-tone signal comprising a first set of CW signals, and

wherein the electronic system is configured to perform the method according to any one of the preceding claims.

## Patentansprüche

1. Verfahren zum Durchführen einer Vektorcharakterisierung basierend auf einer Skalarmessung, das Verfahren umfassend die folgenden Schritte:

   a) Generieren eines Mehrtonsignals mittels einer Signalgenerierungsvorrichtung (12), wobei das Mehrtonsignal mindestens drei Dauerstrichsignale (CW-Signale) umfasst, die mindestens drei CW-Signale einen gewissen Frequenzabstand aufweisen, sodass jedes der drei CW-Signale eine unterschiedliche Mittenfrequenz aufweist, und wobei die Signalgenerierungsvorrichtung (12) konfiguriert ist, um Phasen der mindestens drei CW-Signale zu variieren;

   b) Bestimmen einer mittleren Leistung des Mehrtonsignals und einer Spitzenleistung des Mehrtonsignals mittels einer Skalarmessvorrichtung (14), wobei die mittlere Leistung und die Spitzenleistung auf mindestens einer zuvor bestimmten Referenzebene (34, 42, 48) gemessen werden; und

   c) Variieren einer Phase von mindestens einem der mindestens drei CW-Signale mittels der Signalgenerierungsvorrichtung (12), sodass ein Verhältnis der Spitzenleistung und der mittleren Leistung minimiert oder maximiert wird, wobei dadurch ein erstes Mehrtonsignal, umfassend einen ersten Satz von CW-Signalen, erhalten wird;

   wobei das Verfahren verwendet wird, um einen Signalgenerator zu kalibrieren, um Messungen von Übertragungscharakteristiken und/oder Reflektivitätscharakteristiken eines Prüflings (36) durchzuführen und/oder um einen Frequenzkamm mit vordefinierten Eigenschaften zu generieren.

2. Verfahren nach Anspruch 1, wobei die Signalgenerierungsvorrichtung (12) ein Vektorsignalgenerator ist.

3. Verfahren nach einem der vorstehenden Ansprüche, wobei die Signalgenerierungsvorrichtung (12) konfiguriert ist, um Amplituden der mindestens drei CW-Signale zu variieren, wobei insbesondere die Amplituden der mindestens drei CW-Signale basierend auf der mittleren Leistung eingestellt werden.

4. Verfahren nach einem der vorstehenden Ansprüche, wobei ein Verhältnis von Spitzen- zu Durchschnittsleitung des Mehrtonsignals minimiert oder maximiert wird.

5. Verfahren nach einem der vorstehenden Ansprüche, wobei die mindestens eine zuvor bestimmte Referenzebene (34, 42, 48) einem Eingang (38) eines Prüflings (36), einem Ausgang (40) eines Prüflings (36), einem Reflexionsbereich (46), der einem Eingang (38) eines Prüflings (36) zugeordnet ist, einem Reflexionsbereich, der einem Ausgang (40) eines Prüflings (36) zugeordnet ist, einem Eingang eines Signalanalysators und/oder einem Ausgang der Signalgenerierungsvorrichtung (12) entspricht.

6. Verfahren nach Anspruch 5, wobei die Signalgenerierungsvorrichtung (12) durch Variieren der Phase des mindestens einen der mindestens drei CW-Signale kalibriert und/oder eingestellt wird.

7. Verfahren nach Anspruch 5 oder 6, wobei die Schritte a) bis c) an mindestens zwei unterschiedlichen zuvor bestimmten Referenzebenen (34, 42, 48) durchgeführt werden, insbesondere an dem Eingang (38) des Prüflings (36) und an dem Ausgang (40) des Prüflings (36), an dem Eingang (38) des Prüflings (36) und in dem Reflexionsbereich (46), der dem Eingang (38) des Prüflings (36) zugeordnet ist, oder an dem Ausgang (40) des Prüflings (36) und in dem Reflexionsbereich, der dem Ausgang (40) des Prüflings (36) zugeordnet ist.

8. Verfahren nach Anspruch 7, wobei Übertragungscharakteristiken des Prüflings (36) basierend auf einem Vergleich der zwei Iterationen der Schritte a) bis c) an den mindestens zwei unterschiedlichen zuvor bestimmten Referenzebenen (34, 42, 48) bestimmt werden.

9. Verfahren nach einem der vorstehenden Ansprüche, wobei die mindestens drei CW-Signale in einer Frequenzdomäne gleichmäßig beabstandet sind, wobei insbesondere ein Frequenzabstand der mindestens drei CW-Signale so klein wie möglich ist.

10. Verfahren nach einem der vorstehenden Ansprüche, wobei die Phase von einem der mindestens drei CW-Signale des ersten Satzes von CW-Signalen um 180° verschoben wird, wobei dadurch ein zweites Mehrtonsignal, umfassend einen zweiten Satz von CW-Signalen, erhalten wird.

11. Verfahren nach Anspruch 10, wobei die mittlere Leistung des zweiten Mehrtonsignals und die Spitzenleistung des zweiten Mehrtonsignals, entsprechend dem zweiten Satz von CW-Signalen, bestimmt werden, wobei insbesondere ein Verhältnis der Spitzenleistung und der mittleren Leistung des zweiten Mehrtonsignals mit einem Maximum oder Minimum des Verhältnisses der Spitzenleistung und der mittleren Leistung verglichen wird.

12. Verfahren nach einem der vorstehenden Ansprüche, wobei das erste Mehrtonsignal mittels mindestens einer weiteren elektronischen Komponente (15) verarbeitet wird, bevor die mittlere Leistung und die Spitzenleistung bestimmt werden, wobei insbesondere die mindestens eine weitere elektronische Komponente mindestens einen von einem Filter (28), einem Verstärker (30), einem Frequenzwandler (26), einem Digital-Analog-Wandler, einem Signalleiter (32) und einem Richtkoppler (44) umfasst.

13. Verfahren nach einem der vorstehenden Ansprüche, wobei dem ersten Satz von CW-Signalen mindestens ein weiteres CW-Signal hinzugefügt wird, wobei dadurch ein erweitertes Mehrtonsignal, umfassend mindestens vier CW-Signale, erhalten wird, wobei insbesondere die Schritte b) und c) für das erweiterte Mehrtonsignal wiederholt werden.

14. Verfahren nach einem der vorstehenden Ansprüche, wobei ein Frequenzabstand des ersten Satzes von CW-Signalen vergrößert wird, wobei dadurch ein Mehrtonsignal erhalten wird, umfassend einen Satz von CW-Signalen, der einen größeren Frequenzabstand als der erste Satz von CW-Signalen aufweist.

15. Verfahren nach einem der vorstehenden Ansprüche, wobei eine Mittenfrequenz des ersten Satzes von CW-Signalen variiert wird, wobei dadurch ein frequenzmodifizierter Satz von CW-Signalen erhalten wird, und wobei der Schritt des Bestimmens der mittleren Leistung und der Spitzenleistung sowie der Schritt des Variierens der Phase für den frequenzmodifizierten Satz von CW-Signalen wiederholt wird.

16. Elektronisches System zum Durchführen einer Vektorcharakterisierung basierend auf einer Skalarmessung, das elektronische System (10) umfassend eine Signalgenerierungsvorrichtung (12), eine Skalarmessvorrichtung (14) und eine Steuerung (25),

wobei die Signalgenerierungsvorrichtung (12) konfiguriert ist, um ein Mehrtonsignal zu generieren, wobei das Mehrtonsignal mindestens drei Dauerstrichsignale (CW-Signale) umfasst, wobei die mindestens drei Dauerstrichsignale einen gewissen Frequenzabstand aufweisen, sodass jedes der drei CW-Signale eine unterschiedliche Mittenfrequenz aufweist, wobei die Signalgenerierungsvorrichtung (12) konfiguriert ist, um Phasen der mindestens drei CW-Signale zu variieren,

wobei die Skalarmessvorrichtung (14) konfiguriert ist, um eine mittlere Leistung des Mehrtonsignals und eine Spitzenleistung des Mehrtonsignals auf mindestens einer zuvor bestimmten Referenzebene (34, 42, 48) zu bestimmen,

wobei die Steuerung (25) konfiguriert ist, um die Signalgenerierungsvorrichtung (12) zu steuern, um eine Phase von mindestens einem der mindestens drei CW-Signale zu variieren, sodass ein Verhältnis der Spitzenleistung und der mittleren Leistung minimiert oder maximiert wird, wobei dadurch ein erstes Mehrtonsignal, umfassend einen ersten Satz von CW-Signalen, erhalten wird und

wobei das elektronische System konfiguriert ist, um das Verfahren nach einem der vorstehenden Ansprüche durchzuführen.

## Revendications

1. Procédé permettant d'effectuer une caractérisation de vecteur en fonction d'une mesure scalaire, le procédé comprenant les étapes suivantes :

a) la génération d'un signal multitonalité au moyen d'un dispositif de génération de signaux (12), dans lequel le signal multitonalité comprend au moins trois signaux à ondes continues (CW), les au moins trois signaux CW ayant un certain espacement de fréquence de telle sorte que chacun des trois signaux CW a une fréquence centrale différente, et dans lequel le dispositif de génération de signaux (12) est configuré pour faire varier les phases des au moins trois signaux CW ;
b) la détermination d'une puissance moyenne du signal multitonalité et d'une puissance de crête du signal multitonalité au moyen d'un dispositif de mesure scalaire (14), dans lequel la puissance moyenne et la puissance de crête sont mesurées sur au moins un plan de référence prédéterminé (34, 42, 48) ; et
c) la variation de la phase d'au moins un des au moins trois signaux CW au moyen du dispositif de génération de signaux (12) de telle sorte que le rapport entre la puissance de crête et la puissance moyenne soit minimisé ou maximisé, ce qui permet d'obtenir un premier signal multitonalité comprenant un premier ensemble de signaux CW ;

dans lequel le procédé est utilisé pour étalonner un générateur de signaux, pour effectuer des mesures des caractéristiques de transfert et/ou des caractéristiques de réflectivité d'un dispositif testé (36), et/ou pour générer un peigne de fréquences ayant des propriétés prédéfinies.

2. Procédé selon la revendication 1, dans lequel le dispositif de génération de signaux (12) est un générateur de signaux vectoriels.

3. Procédé selon l'une quelconque des revendications précédentes, dans lequel le dispositif de génération de signaux (12) est configuré pour faire varier les amplitudes des au moins trois signaux CW, en particulier dans lequel les amplitudes des au moins trois signaux CW sont définies sur la base de la puissance moyenne.

4. Procédé selon l'une quelconque des revendications précédentes, dans lequel le rapport puissance de crête/puissance moyenne du signal multitonalité est minimisé ou maximisé.

5. Procédé selon l'une quelconque des revendications précédentes, dans lequel l'au moins un plan de référence prédéterminé (34, 42, 48) correspond à une entrée (38) d'un dispositif testé (36), à une sortie (40) d'un dispositif testé (36), à une région de réflexion (46) associée à une entrée (38) d'un dispositif testé (36), à une région de réflexion associée à une sortie (40) d'un dispositif testé (36), à une entrée d'un analyseur de signaux, et/ou à une sortie du dispositif de génération de signaux (12).

6. Procédé selon la revendication 5, dans lequel le dispositif de génération de signaux (12) est calibré et/ou réglé en faisant varier la phase de l'au moins un des au moins trois signaux CW.

7. Procédé selon la revendication 5 ou 6, dans lequel les étapes a) à c) sont effectuées sur au moins deux plans de référence prédéterminés différents (34, 42, 48), en particulier à l'entrée (38) du dispositif testé (36) et à la sortie (40) du dispositif testé (36), à l'entrée (38) du dispositif testé (36) et dans la zone de réflexion (46) associée à l'entrée (38) du dispositif testé (36), ou à la sortie (40) du dispositif testé (36) et dans la zone de réflexion associée à la sortie (40) du dispositif testé (36).

8. Procédé selon la revendication 7, dans lequel les caractéristiques de transfert du dispositif testé (36) sont déterminées sur la base d'une comparaison des deux itérations des étapes a) à c) aux au moins deux plans de référence prédéterminés différents (34, 42, 48).

9. Procédé selon l'une quelconque des revendications précédentes, dans lequel les au moins trois signaux CW sont également espacés dans le domaine des fréquences, en particulier dans lequel l'espacement des fréquences des au moins trois signaux CW est aussi faible que possible.

10. Procédé selon l'une quelconque des revendications précédentes, dans lequel la phase de l'un des au moins trois signaux CW du premier ensemble de signaux CW est décalée de 180°, ce qui permet d'obtenir un second signal multitonalité comprenant un second ensemble de signaux CW.

11. Procédé selon la revendication 10, dans lequel la puissance moyenne du second signal multitonalité et la puissance de crête du second signal multitonalité correspondant au second ensemble de signaux CW sont déterminées, en particulier dans lequel un rapport entre la puissance de crête et la puissance moyenne du second signal multitonalité est comparé à un maximum ou à un minimum du rapport entre la puissance de crête et la puissance moyenne.

12. Procédé selon l'une quelconque des revendications précédentes, dans lequel le premier signal multitonalité est traité au moyen d'au moins un autre composant électronique (15) avant que la puissance moyenne et la puissance de crête ne soient déterminées, en particulier dans lequel l'au moins un autre composant électronique comprend au moins l'un parmi un filtre (28), un amplificateur (30), un convertisseur de fréquence (26), un convertisseur numérique-analogique, un conducteur de signal (32) et un coupleur directionnel (44).

13. Procédé selon l'une quelconque des revendications précédentes, dans lequel au moins un autre signal CW est ajouté au premier ensemble de signaux CW, ce qui permet d'obtenir un signal multitonalité étendu comprenant au moins quatre signaux CW, en particulier dans lequel les étapes b) et c) sont répétées pour le signal multitonalité étendu.

14. Procédé selon l'une quelconque des revendications précédentes, dans lequel un espacement de fréquence du premier ensemble de signaux CW est augmenté, ce qui permet d'obtenir un signal multitonalité comprenant un ensemble de signaux CW ayant un espacement de fréquence plus grand que le premier ensemble de signaux CW.

15. Procédé selon l'une quelconque des revendications précédentes, dans lequel une fréquence centrale du premier ensemble de signaux CW varie, ce qui permet d'obtenir un ensemble de signaux CW à fréquence modifiée, et dans lequel l'étape de détermination de la puissance moyenne et de la puissance de crête ainsi que l'étape de variation de la phase sont répétées pour l'ensemble de signaux CW à fréquence modifiée.

16. Système électronique permettant d'effectuer une caractérisation de vecteur en fonction d'une mesure scalaire, le système électronique (10) comprenant un dispositif de génération de signaux (12), un dispositif de mesure scalaire (14) et un dispositif de commande (25),

dans lequel le dispositif de génération de signaux (12) est configuré pour générer un signal multitonalité, dans lequel le signal multitonalité comprend au moins trois signaux à ondes continues (CW), les au moins trois signaux à ondes continues ayant un certain espacement de fréquence de telle sorte que chacun des trois signaux CW a une fréquence centrale différente, dans lequel le dispositif de génération de signaux (12) est configuré pour faire varier les phases des au moins trois signaux CW,

dans lequel le dispositif de mesure scalaire (14) est configuré pour déterminer une puissance moyenne du signal multitonalité et une puissance de crête du signal multitonalité sur au moins un plan de référence prédéterminé (34, 42, 48),

dans lequel le dispositif de commande (25) est configuré pour commander le dispositif de génération de signaux (12) afin de faire varier la phase d'au moins un des au moins trois signaux CW de telle sorte que le rapport entre la puissance de crête et la puissance moyenne soit minimisé ou maximisé, ce qui permet d'obtenir un premier signal multitonalité comprenant un premier ensemble de signaux CW, et

dans lequel le système électronique est configuré pour exécuter le procédé selon l'une quelconque des revendications précédentes.

**Fig. 1**

**Fig. 2**

# Fig. 3

# Fig. 4

S1 — generate multi-tone signal comprising
at least three CW signals

S2 — determine ratio of mean power and
peak power of the multi-tone signal
at a first reference plane

S3 — vary phase(s) of at least one CW signal
until ratio is maximized or minimized

S4 — repeat steps S2 and S3
at further reference
plane and determine
DUT characteristics

S5 — add further CW signals
and generate custom
frequency comb

# Fig. 5

## (a)

3-Carrier Average, and Peak Envelope,
Power vs Phasing

## (b)

Peak-to-Average Power Ratio
vs Carrier Phase Difference

## (c)

## (d)

# Fig. 6

**(a)** Set amplitude CW1
Measure Average Power

**(b)** Set amplitude CW2
Measure Average Power

**(c)** Set amplitude CW3
Measure Average Power

**(d)** 2D search of 2x Phase Deltas
Measure Peak-to-Average Power Ratio (PAPR)

**(e)** 2D search of $3^{rd}$ Tone Amplitude & Phase, swept across a frequency raster. $1^{st}$ and $2^{nd}$ Tone are unchanged.

**(f)** Check PAPR with in-phase and anti-phase at each frequency, to verify the alignment quality.

**Fig. 7**

(a)

(b)

(c)

(d)

(e)

(f)

(g)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- *Agilent Two-tone and Multitone Personalities for the E8267C PSG Vector Signal Generator*, 06 February 2003, http://anlage.umd.edu/5988-7689EN.pdf
- MULTITONE SIGNAL GENERATORS FOR CELLULAR AND PCS HPA EVALUATION. MICROWAVE JOURNAL. HORIZON HOUSE PUBLICATIONS, 01 May 1999, vol. 42, 354, 360

- Difference between single-tone and multi-tone excitations in RF channel measurement. **GUO XIAO-TAO et al.** PROCEEDINGS OF 2014 3RD ASIA PACIFIC CONFERENCE ON ANTENNAS AND PROPAGATION. IEEE, 26 July 2014, 806-809